# EUROPÄISCHE PATENTSCHRIFT

(11) **EP 1 256 010 B1**
(45) Veröffentlichungstag und Bekanntmachung des Hinweises auf die Patenterteilung: **02.01.2008**
(21) Anmeldenummer: 01989392.4
(22) Anmeldetag: 08.12.2001
(51) Int. Cl.: G01R 33/06

(54) **VORRICHTUNG ZUR SENSIERUNG EINES MAGNETFELDES, MAGNETFELDMESSER UND STROMMESSER**
DEVICE FOR DETECTING A MAGNETIC FIELD, MAGNETIC FIELD MEASURER AND CURRENT METER
DISPOSITIF POUR DETECTER UN CHAMP MAGNETIQUE, APPAREIL DE MESURE DE CHAMP MAGNETIQUE ET AMPEREMETRE

(30) Priorität: 09.01.2001 DE 10100598
(43) Veröffentlichungstag der Anmeldung: 13.11.2002
(73) Patentinhaber: ROBERT BOSCH GMBH, 70442 Stuttgart (DE)
(72) Erfinder: HAUENSTEIN, M., Henning, 72762 Reutlingen (DE)
(86) Internationale Anmeldenummer: PCT/DE2001/004633
(87) Internationale Veröffentlichungsnummer: WO 2002/056046

(56) Entgegenhaltungen:
- GB-A- 1 280 719
- US-A- 5 179 429
- US-A- 5 514 899
- TRUJILLO H ET AL: "MERGED LATERAL BIPOLAR MAGNETOTRANSISTORS" SENSORS AND ACTUATORS A, ELSEVIER SEQUOIA S.A., LAUSANNE, CH, Bd. 50, Nr. 3, 1. September 1995 (1995-09-01), Seiten 177-181, XP000584887 ISSN: 0924-4247

## Beschreibung

### Stand der Technik

Die Zahl der Einsatzbereiche für Magnetfeldsensoren wächst zunehmend, insbesondere im Automobilbereich. Die Magnetfeldmessung kann unter anderem zur berührungslosen, verlustarmen und potentialfreien Messung von Strömen genutzt werden. Beispiele sind die Bestimmung elektrischer Betriebsparameter von Generatoren und elektrischen Antrieben. Im Allgemeinen müssen Ströme vom Milliampere- bis zum Kiloamperebereich gemessen werden, was einen Meßbereich von fünf bis sechs Größenordnungen erfordert.

Stand der Technik ist es heute, magnetische Felder, beispielsweise von Stromleitern, durch Magnetfeldsensoren, wie beispielsweise Hall-Sensoren, bipolare Magnetotransistoren, magnetoresistive Widerstände, laterale Magneto-FET-Strukturen etc., zu messen. Ein besonders empfindliches Bauelement ist der sogenannte laterale Magnetotransistor, dessen Funktion auf der durch das Magnetfeld erzeugten asymmetrischen Stromverteilung zwischen zwei bipolaren Transistoren beruht.

Für Ströme im Milliampere-Bereich stoßen selbst solche Bauelemente aufgrund der geringen Magnetfelder, typischerweise im µT-Bereich an die Grenzen ihrer Empfindlichkeit. Daher werden beim Stand der Technik kleine Magnetfelder durch sogenannte Flußkonzentratoren verstärkt, bei denen man durch geeignete Formgebung der jeweiligen Stromleiter oder durch Magnetkreise aus hochpermeablen Materialien erreicht, dass die Magnetfelder am Ort der Magnetfeldsensoren stärker sind.

Aus der Druckschrift "Sensors and Actuators A 50 (1995), Seite 177 bis 181, XP000584887 ISSN: 0924-4247 ist unter dem Titel "Merged lateral bipolar magnetotransistors" von H. TRUJILLO et al. bekannt, eine Vorrichtung zur Sensierung eines Magnetfeldes mit zwei lateralen Magnetotransistoren aufzubauen, wobei die beiden Magnetotransistoren komplementär aufgebaut sind.

### Vorteile der Erfindung

Die erfindungsgemäße Vorrichtung zur Sensierung eines Magnetfeldes, der erfindungsgemäße Magnetfeldmesser und der erfindungsgemäße Strommesser haben demgegenüber den Vorteil, dass auf flußkonzentrierende Hilfsmittel verzichtet werden kann, was Kosten einspart und den benötigten Bauraum reduziert. Dies ist dadurch möglich, dass die Empfindlichkeit der erfindungsgemäßen Vorrichtung gesteigert wird. Hierbei bleibt der lineare Zusammenhang zwischen dem Meßsignal und dem zu messenden Magnetfeld weitgehend erhalten.

Durch die in den Unteransprüchen aufgeführten Maßnahmen sind vorteilhafte Weiterbildungen und Verbesserungen der in den nebengeordneten Ansprüchen angegebenen Vorrichtung, des Magnetfeldmessers und des Strommessers möglich.

Besonders vorteilhaft ist, dass die lateralen Magnetotransistoren insofern komplementär vorgesehen sind, als der erste laterale Magnetotransistor vom npn-Typ und dass der zweite laterale Magnetotransistor vom pnp-Typ ist. Dadurch ist es möglich, zwei komplementäre laterale Magnetotransistoren mit einfachen Mitteln vorzusehen.

Dadurch können die komplementären lateralen Magnetotransistoren auch zu einer automatischen Offset- oder Temperaturkompensation genutzt werden.

Weiterhin ist von Vorteil, dass der erste laterale Magnetotransistor einen ersten Ausgang und einen zweiten Ausgang aufweist, dass der zweite laterale Magnetotransistor einen dritten und einen vierten Ausgang aufweist, dass der erste und der dritte Ausgang niederohmig verbunden sind, dass der zweite und der vierte Ausgang niederohmig verbunden sind und dass eine Meßbrücke zwischen dem ersten und dem vierten Ausgang vorgesehen ist. Dadurch kann eine Spannung oder ein Strom über die Meßbrücke direkt auf dem Halbleiterchip abgegriffen werden, auf dem die lateralen Magnetotransistoren realisiert sind, ohne dass zusätzliche Shunt-Widerstände oder eine externe Beschaltung benötigt werden. Das Signal-/Rausch-Verhältnis wird dadurch gegenüber einem LMT-Sensor mit einem einzelnen lateralen Magnetotransistor verbessert. Die Meßbrücke ist hochsensitiv und kann daher sehr genau abgeglichen werden, beispielsweise durch eine Nullpunkteinstellung ohne externes Magnetfeld. Weiterhin kann der Meßbrückenabgleich, z.B. Offset-Kompensation, sehr einfach erfolgen, beispielsweise über leichte Änderungen des Arbeitspunktes eines der beteiligten lateralen Magnetotransistoren. Analog können Temperaturdriften kompensiert werden.

Weiterhin ist von Vorteil, dass die lateralen Magnetotransistoren monolithisch integriert vorgesehen sind. Dadurch kann die komplementäre laterale Magnetotransistor-Sensoranordnung auf einem Chip realisiert werden, wodurch ein hochempfindliches Sensorelement entsteht. Weiterhin kann dadurch eine Auswerteschaltung auf dem Chip vorgesehen werden, die zur Verstärkung des Meßbrückensignals dient. Weiterhin erfordert die Realisierung der komplementären lateralen Magnetotransistoren auf einem Chip keinen wesentlichen Zusatzaufwand bei der Fertigung.

### Zeichnung

Ein Ausführungsbeispiel der Erfindung ist in der Zeichnung dargestellt und in der nachfolgenden Beschreibung näher erläutert. Es zeigen
Figur 1 einen lateralen Magnetotransistor,
Figur 2 ein schematisches Ersatzschaltbild für eine Kombination zweier komplementärer lateraler Magnetotransistoren mit einer Brückenanordnung und
Figur 3 ein stark vereinfachtes Ersatzschaltbild für die Brückenanordnung.

### Beschreibung des Ausführungsbeispiels

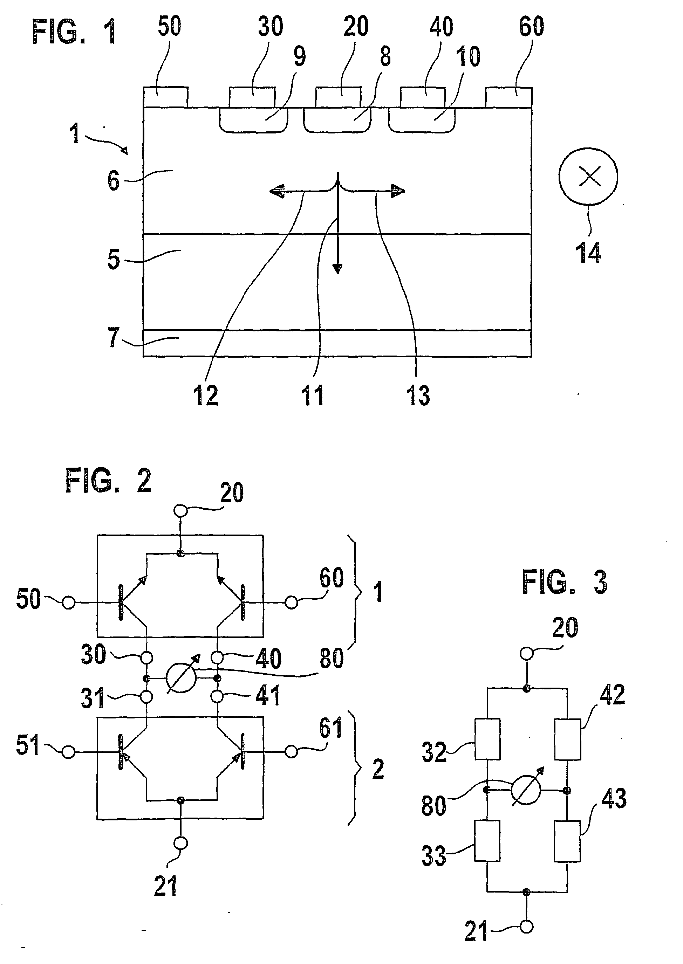

In Figur 1 ist ein lateraler Magnetotransistor 1 dargestellt. Der laterale Magnetotransistor 1 wird auch mit LMT 1 abgekürzt. Der LMT 1 umfasst eine erste Halbleitersubstratschicht 5, welche bei einem LMT vom npn-Typ negativ dotiert ist. Weiterhin weist der LMT 1 eine zweite Halbleitersubstratschicht 6 auf, welche für den npn-Typ positiv dotiert ist. Unterhalb der ersten Halbleitersubstratschicht 5 ist eine erste Metallisierungsschicht 7 zur Kontaktierung vorgesehen. Die erste Metallisierungsschicht 7 bildet den Vertikalkollektor des LMT 1. In der zweiten Halbleitersubstratschicht 6 ist ein erster Halbleitersubstratbereich 8 eingebettet, welcher beim npn-Typ negativ dotiert ist und welcher beim pnp-Typ positiv dotiert ist. Weiterhin ist benachbart zu dem ersten Halbleitersubstratbereich 8 ein zweiter Halbleitersubstratbereich 9 und ein dritter Halbleitersubstratbereich 10 in die zweite Halbleitersubstratschicht 6 eingebettet, wobei der erste Halbleiterbereich 8 in der Mitte zwischen dem Halbleitersubstratbereich 9 und dem dritten Halbleitersubstratbereich 10 liegt. Der zweite und der dritte Halbleitersubstratbereich 9, 10 sind ebenso wie der erste Halbleitersubstratbereich 8 dotiert. Oberhalb des ersten Halbleitersubstratbereichs 8 ist eine erste metallische Kontaktierung 20 angeordnet, die den Emitterkontakt des LMT 1 bildet. Oberhalb des zweiten Halbleitersubstratbereichs 9 ist eine zweite Metallkontaktierung 30 vorgesehen, die einen ersten Kollektor des LMT bildet. Oberhalb des dritten Halbleitersubstratbereichs 10 ist eine dritte Metallkontaktierung 40 vorgesehen, die einen zweiten Kollektor des LMT 1 bildet. Neben der zweiten Metallkontaktierung 30 befindet sich auf der der ersten Metallkontaktierung 20 gegenüberliegenden Seite eine vierte Metallkontaktierung 50, die einen ersten Basisanschluß des LMT 1 bildet. Neben der dritten Metallkontaktierung 40 befindet sich gegenüber der ersten Metallkontaktierung 20 eine fünfte Metallkontaktierung 60, die einen zweiten Basisanschluß des LMT 1 bildet.

In Figur 1 sind die Stromrichtungen von verschiedenen Strömen aufgezeichnet, die beim Betrieb des LMT 1 fließen. Hierbei wurden die Stromrichtungen für einen npn-Typ angegeben. Bei einem pnp-Typ sind die Stromrichtungen umgekehrt zu denken. Bei dem LMT 1 vom npn-Typ fließt ein erster Strom 11 senkrecht aus dem Emitterbereich 8, d.h. aus dem ersten Halbleitersubstratbereich 8, nach unten. Der erste Strom 11 entspricht dem Eingangsstrom des LMT 1, der über den Emitteranschluß 20 eingespeist wird. Beim Betrieb sind die Kollektoranschlüsse 30, 40 auf das gleiche Potential gelegt und es ergibt sich ein zweiter Strom 12 vom Emitterbereich 8 zum zweiten Kollektorbereich 9, d.h. zum ersten Halbleitersubstratbereich 9, und es ergibt sich weiterhin ein dritter Strom 13 vom Emitterbereich 8 zum dritten Kollektorbereich 10, d.h. zum zweiten Halbleitersubstratbereich 10. Bei Abwesenheit eines Magnetfeldes 14 ist der zweite Strom 12 und der dritte Strom 13 gleich groß. Bei Anwesenheit eines Magnetfeldes 14, welches eine Komponente aufweist, die senkrecht in die Bildebene hineinweist, was in der Zeichnung mit einem Kreuz im Magnetfeld 14 angedeutet ist, kommt es zu einem Symmetriebruch hinsichtlich des ersten und des zweiten Stroms 12, 13: einer der Ströme wird größer.

In Figur 2 ist ein schematisches Ersatzschaltbild einer Kombination zweier komplementärer LMT-Elemente dargestellt. Ein erster LMT 1 ist hierbei vom npn-Typ vorgesehen und ein zweiter LMT 2 ist vom pnp-Typ vorgesehen. Der erste LMT 1 weist die aus Figur 1 bekannten Bezugszeichen auf, als da wären der Emitter 20, der erste Basisanschluß 50 und der zweite Basisanschluß 60, der erste Kollektoranschluß 30 und der zweite Kollektoranschluß 40. Der zweite LMT 2 ist komplementär aufgebaut und zwar erfindungsgemäß insbesondere als pnp-Typ. Der zweite LMT 2 weist daher einen Emitter 21, einen ersten Basisanschluß 51 und einen zweiten Basisanschluß 61 sowie einen ersten Kollektor 31 und einen zweiten Kollektor 41 auf. Der erste LMT 1 weist einen ersten Ausgang und einen zweiten Ausgang auf, und der zweite LMT 2 weist einen dritten Ausgang und einen vierten Ausgang auf. Erfindungsgemäß ist vorgesehen, dass der erste Kollektor 30 des ersten LMT 1 den ersten Ausgang bildet, dass weiterhin der zweite Kollektor 40 des ersten LMT 1 den zweiten Ausgang bildet, dass weiterhin der erste Kollektor 31 des zweiten LMT 2 den dritten Ausgang bildet und dass der zweite Kollektor 41 des zweiten LMT 2 den vierten Ausgang bildet. Die beiden ersten Kollektoren 30, 31 der beiden LMTs 1, 2 sind niederohmig verbunden, was bedeutet, dass der erste und der dritte Ausgang niederohmig verbunden sind. Weiterhin sind die zweiten Kollektoren 40, 41 der LMTs 1, 2 niederohmig verbunden, was bedeutet, dass der zweite und vierte Ausgang niederohmig verbunden sind. Weiterhin ist der erste Ausgang und der vierte Ausgang (bzw. umgekehrt) auch der zweite Ausgang und der dritte Ausgang mittels einer Meßbrücke 80 miteinander verbunden. Der Vertikalkollektor 7 des LMT 1 ist in Figur 2 nicht dargestellt, weil er für die Beschreibung der Funktion der Schaltung und für die prinzipielle LMT-Funktion nicht unbedingt notwendig ist.

Die vier Emitterkollektorwiderstände der beiden LMT-Elemente 1, 2 bilden eine Meßbrücke, die z.B. ohne externes Magnetfeld 14 abgeglichen wird und deren Änderung in Gegenwart eines Magnetfeldes sehr genau bestimmt werden kann.

Man kann die Schaltung prinzipiell aus diskreten Komponenten aufbauen. Besonders vorteilhaft ist hier die Realisierung der komplementären LMT-Anordnung als erfindungsgemäße Vorrichtung auf einem einzigen Chip. Vorteil der vorliegenden Erfindung ist, dass das Signal über der Meßbrücke direkt sowohl als Strom oder als Spannung abgegriffen werden kann. Ein konventioneller LMT-Sensor nach dem Stand der Technik benötigt im Allgemeinen externe Widerstände am Ausgang der Lateralkollektoren, um den Spannungsabfall der Kollektorströme zu messen und daraus die vom Magnetfeld induzierten Änderungen zu bestimmen. Die Folgen sind im Allgemeinen eine Beeinträchtigung des Signal-/Rauschverhältnisses durch die externe Beschaltung, beispielsweise hervorgerufen durch Widerstandsrauschen. Diese Effekte können bei einem komplementären LMT-Sensorchip durch das direkt zur Verfügung stehende Meßsignal an der Brücke 80 vermieden werden. Daher ist nicht nur die Empfindlichkeit höher, sondern auch das Signal-/Rauschverhältnis besser als bei einem einzelnen LMT-Element.

In Figur 3 ist ein stark vereinfachtes Ersatzschaltbild für die Brückenanordnung dargestellt. Hierbei entspricht einem ersten Emitterkollektorwiderstand 32 der Widerstand zwischen dem Emitteranschluß 20 und dem ersten Kollektoranschluß 30 des ersten LMT 1. Einem zweiten Emitterkollektorwiderstand 42 entspricht der Widerstand zwischen dem Emitteranschluß 20 und dem zweiten Kollektoranschluß 40 des ersten LMT 1. Weiterhin entspricht einem dritten Emitterkollektorwiderstand 33 der Widerstand zwischen dem Emitter 21 und dem ersten Kollektoranschluß 31 des zweiten LMT 2. Weiterhin entspricht einem vierten Emitterkollektorwiderstand 43 der Widerstand zwischen dem Emitteranschluß 21 und dem zweiten Kollektoranschluß 41 des zweiten LMT 2. In Gegenwart eines externen Magnetfeldes 14 lateral zur Chipfläche ändern sich in jedem der beiden LMT 1, 2 die Stromverteilungen zwischen dem ersten Kollektor 30, 31 und dem zweiten Kollektor 40, 41. Dies entspricht einer Widerstandsänderung der jeweiligen Kollektoremitterstrecken 32, 42, 33, 43 in Figur 3. Je nach Anwendung sind die beiden komplementären LMT 1, 2 geeignet zum zu messenden Magnetfeld 14 zu orientieren. Die Wirkung des Magnetfeldes 14 auf die Widerstandsbrücke 80 kann durch die relative Lage der komplementären LMT 1, 2 zueinander, beispielsweise durch das Chiplayout, oder durch geeignete elektrische Verknüpfung der Kollektoren 30, 40 bzw. 31, 41 anwendungsspezifisch gewählt werden.

Wird die elektrische Verbindung von isolierten LMTs 1, 2 vom npn-Typ und vom pnp-Typ erst nach der Chipherstellung, beispielsweise durch Bonddrähte, Lead-Frames, Flexfolie, usw., hergestellt, dann kann man ein universelles Sensorelement fertigen, dessen Meßbrücke erst nachträglich, den Anwendungsbedingungen entsprechend, beschaltet wird. Denkbar ist auch ein Chip mit mehreren verschiedenen orientierten LMT-Elementen des npn- und pnp-Typs, von denen z.B. zwei ausgewählt und je nach Applikationsanforderung zu einer geeigneten Meßbrücke verbunden werden.

Da mindestens zwei LMT-Sensoren 1, 2 an der Brückenschaltung beteiligt sind, können verschiedene Meßmethoden realisiert werden. Beide LMT-Elemente 1, 2 können so angeordnet werden, dass sie dem gleichen Magnetfeld 14 ausgesetzt sind, wodurch sich die Wirkung des Feldes addiert. Die Sensoren können aber auch so plaziert werden, dass diese verschiedenen Magnetfelder "sehen", d.h. sensieren, beispielsweise für eine Differenz- oder eine Referenz-Messung. Je nach Applikation kann daher die erfindungsgemäße Brückenschaltung sehr flexibel eingesetzt werden.

Hohe Anforderungen an Genauigkeit und Auflösung stellen entsprechend hohe Anforderungen an die Stabilität und den Abgleich des Nullpunktoffsets eines Sensors. Die vorliegende hochgenaue Meßbrückenanordnung ist für entsprechend genaue Abgleichanforderungen besonders vorteilhaft geeignet, weil eine solche Meßbrücke sehr genau eingestellt werden kann. Weiterhin kann der Offset und die Temperaturdrift relativ einfach durch leichtes Anpassen des Arbeitspunktes von einem der vier Kollektoremitterstrecken 32, 42, 33, 43 kompensiert werden.

Erfindungsgemäß werden bei der vorliegenden Vorrichtung auch LMT-Bauelemente verwendet, die keinen Substratkollektor 7 aufweisen.

Erfindungsgemäß ist es insbesondere vorgesehen, die erfindungsgemäße Vorrichtung als Magnetfeldmesser vorzusehen, wobei ein solcher Magnetfeldmesser außer der beschriebenen Vorrichtung bestehend aus den beiden LMTs 1, 2 weiterhin eine Auswerteschaltung bzw. eine Ansteuerschaltung umfasst.

Weiterhin ist vorgesehen, dass ein hochempfindlicher Magnetfeldsensor bzw. Magnetfeldmesser oder die erfindungsgemäße Vorrichtung zur Strommessung herangezogen wird, wobei die Magnetfeldwirkung um einen stromdurchflossenen Leiter ausgenutzt wird.

## Patentansprüche

1. Vorrichtung zur Sensierung eines Magnetfeldes (14) mit einem ersten lateralen Magnetotransistor (1) und einem zweiten lateralen Magnetotransistor (2), wobei der erste und der zweite laterale Magnetotransistor (1, 2) komplementär vorgesehen sind und der erste laterale Magnetotransistor (1) vom npn-Typ ist und der zweite laterale Magnetotransistor (2) vom pnp-Typ ist, wobei der erste laterale Magnetotransistor (1) einen ersten Ausgang (30) und einen zweiten Ausgang (40) aufweist und der zweite laterale Magnetotransistor (2) einen dritten Ausgang (31) und einen vierten Ausgang (41) aufweist und der erste und der dritte Ausgang (30, 31) niederohmig verbunden sind und der zweite und der vierte Ausgang (40, 41) niederohmig verbunden sind und eine Meßbrücke (80) zwischen dem ersten und vierten Ausgang (30, 41) vorgesehen ist.

2. Vorrichtung nach Anspruch 1, **dadurch gekennzeichnet, dass** der erste und der dritte Ausgang (30, 31) komplementär sind und dass der zweite und der vierte Ausgang (40, 41) komplementär sind.

3. Vorrichtung nach Anspruch 1 oder 2, **dadurch gekennzeichnet, dass** die Ausgänge (30, 31, 40, 41) als Kollektor-Anschlüsse des ersten und zweiten lateralen Magnetotransistors (1, 2) vorgesehen sind.

4. Vorrichtung nach einem der vorhergehenden Ansprüche, **dadurch gekennzeichnet, dass** die lateralen Magnetotransistoren (1, 2) monolithisch integriert vorgesehen sind.

5. Magnetfeldmesser mit einer Vorrichtung nach einem der vorhergehenden Ansprüche

6. Strommesser mit einer Vorrichtung oder einem Magnetfeldmesser nach einem der vorhergehenden Ansprüche.

## Claims

1. Apparatus for sensing a magnetic field (14) having a first lateral magnetotransistor (1) and a second lateral magnetotransistor (2), with the first and the second lateral magnetotransistors (1, 2) being provided in a complementary form, with the first lateral magnetotransistor (1) being of the npn type and the second lateral magnetotransistor (2) being of the pnp type, with the first lateral magnetotransistor (1) having a first output (30) and a second output (40), and with the second lateral magnetotransistor (2) having a third output (31) and a fourth output (41), and with the first and the third outputs (30, 31) being connected with a low impedance, and with the second and the fourth outputs (40, 41) being connected with a low impedance, and with a measurement bridge (80) being provided between the first and the fourth outputs (30, 41).

2. Apparatus according to Claim 1, **characterized in that** the first and the third outputs (30, 31) are complementary, and **in that** the second and the fourth outputs (40, 41) are complementary.

3. Apparatus according to Claim 1 or 2, **characterized in that** the outputs (30, 31, 40, 41) are provided as collector connections of the first and second lateral magnetotransistors (1, 2).

4. Apparatus according to one of the preceding claims, **characterized in that** the lateral magnetotransistors (1, 2) are provided in a monolithically integrated form.

5. Magnetic field measuring device having an apparatus according to one of the preceding claims.

6. Ammeter having an apparatus or a magnetic field sensor according to one of the preceding claims.

## Revendications

1. Dispositif de détection d'un champ magnétique (14) comprenant un premier magnéto-transistor (1), latéral, et un second magnéto-transistor latéral (2),
le premier et le second magnéto-transistor étant complémentaires et le premier magnéto-transistor latéral (2) est de type npn, le second magnéto-transistor latéral (2) étant de type pnp,
le premier magnéto-transistor latéral ayant une première sortie (30) et une seconde sortie (40),
le second magnéto-transistor latéral (2) ayant une troisième sortie (31) et une quatrième sortie (41),
la première et la troisième sortie (30, 31) étant reliées par une liaison faiblement ohmique,
la seconde et la quatrième sortie (40, 41) étant reliées par une liaison faiblement ohmique, et
un pont de mesure (80) étant prévu entre la première et la quatrième sortie (30, 41).

2. Dispositif selon la revendication 1,
**caractérisé en ce que**
la première et la troisième sortie (30, 31) sont complémentaires et
la seconde et la quatrième sortie (40, 41) sont complémentaires.

3. Dispositif selon la revendication 1 ou 2,
**caractérisé en ce que**
les sorties (30, 31, 40, 41) sont des montages de collecteurs du premier et du second magnéto-transistor latéral (1, 2).

4. Dispositif selon l'une des revendications précédentes,
**caractérisé en ce que**
les magnéto-transistors latéraux (1, 2) sont des composants monolithiques intégrés.

5. Appareil de mesure de champ magnétique comportant un dispositif selon l'une des revendications précédentes.

6. Ampèremètre comportant un dispositif ou un appareil de mesure de champs magnétiques selon l'une des revendications précédentes.
